# EUROPEAN PATENT APPLICATION

(11) **EP 4 730 979 A1**
(43) Date of publication of application: **22.04.2026**
(21) Application number: 25201548.2
(22) Date of filing: 11.09.2025
(51) Int. Cl.: H10W 20/42, H10D 30/00, H10D 30/67, H10D 62/10, H10D 84/01, H10W 20/41, H10W 20/40, H10D 64/23

(54) **SEMICONDUCTOR DEVICE**

(30) Priority: 15.10.2024 KR 20240140577
(71) Applicant: Samsung Electronics Co., Ltd., Suwon-si, Gyeonggi-do 16677 (KR)
(72) Inventor: SHIN, Taeyeon, 16677 Suwon-si (KR); KIM, Dongwoo, 16677 Suwon-si (KR); KIM, Chulsung, 16677 Suwon-si (KR); KIM, Hyunwoo, 16677 Suwon-si (KR)
(74) Representative: Marks & Clerk LLP

(57) **Abstract**

A semiconductor device includes: a semiconductor pattern, a plurality of channel structures including a plurality of channel patterns, a plurality of gate structures, source/drain patterns that are on the semiconductor pattern and are on side surfaces of the plurality of channel patterns, a dielectric isolation layer, a plurality of dielectric isolation patterns, a plurality of contact blocks, at least one contact via that extends from at least one contact block into the dielectric isolation layer to respectively contact at least one source/drain pattern among the source/drain patterns, a conductive barrier that is between the dielectric isolation layer and the plurality of contact blocks and contacts the at least one contact via, and an interconnection structure that is on lower surfaces of the plurality of contact blocks, is on the plurality of dielectric isolation patterns, and is electrically connected to the at least one contact block.

## Description

### TECHNICAL FIELD

The present disclosure relates to a semiconductor device.

### BACKGROUND

As demand for high performance, high speed, and/or multifunctionality of semiconductor devices has increased, the integration of semiconductor devices has increased. In accordance with the trend for high integration of semiconductor devices, semiconductor devices having a backside power delivery network (BSPDN) structure in which power rails are disposed on backsides of wafers have been developed. In addition, efforts have been made to develop semiconductor devices having a three-dimensional channel structure in order to overcome the limitations of operating characteristics due to a size reduction of planar metal oxide semiconductor field effect transistors (MOSFETs).

### SUMMARY

An aspect of the present disclosure is to provide a semiconductor device having improved electrical characteristics and reliability.

According to an aspect of the present disclosure, a semiconductor device includes: a semiconductor pattern that extends in a first direction, a plurality of channel structures that are spaced apart from each other in the first direction and are on the semiconductor pattern, where each of the plurality of channel structures includes a plurality of channel patterns, a plurality of gate structures that are on the plurality of channel structures, extend in a second direction that intersects the first direction, and extends around the plurality of channel patterns, source/drain patterns that are on the semiconductor pattern and are on side surfaces of the plurality of channel patterns, a dielectric isolation layer on a lower surface of the semiconductor pattern, a plurality of dielectric isolation patterns that extend toward the plurality of gate structures in a third direction that is perpendicular to the first direction, a plurality of contact blocks that are respectively between adjacent ones of the plurality of dielectric isolation patterns and are on a lower surface of the dielectric isolation layer, at least one contact via that extends from at least one contact block of the plurality of contact blocks into the dielectric isolation layer to respectively contact at least one source/drain pattern among the source/drain patterns, a conductive barrier that is between the dielectric isolation layer and the plurality of contact blocks and contacts the at least one contact via, where each of the plurality of contact blocks includes a side surface that respectively contacts sidewalls of the plurality of dielectric isolation patterns, and an interconnection structure that is on lower surfaces of the plurality of contact blocks, is on the plurality of dielectric isolation patterns, and is electrically connected to the at least one contact block.

According to another aspect of the present disclosure, a semiconductor device includes: a semiconductor pattern that extends in a first direction, a device isolation layer that is on opposing side surfaces of the semiconductor pattern and extends in the first direction, a plurality of channel structures that are spaced apart from each other in the first direction and are on the semiconductor pattern, a plurality of gate structures that are on the plurality of channel structures and extend in a second direction that intersects the first direction, source/drain patterns that are respectively between the plurality of channel structures and are on the semiconductor pattern, a dielectric isolation layer on a lower surface of the semiconductor pattern, a plurality of dielectric isolation patterns that extend toward the plurality of gate structures in a third direction that is perpendicular to the first direction, a plurality of contact blocks that are respectively between adjacent ones of the plurality of dielectric isolation patterns and are on a lower surface of the dielectric isolation layer, at least one contact via that extends from at least one contact block of the plurality of contact blocks into the dielectric isolation layer to respectively contact at least one source/drain pattern among the source/drain patterns, a conductive barrier that is between the dielectric isolation layer and the plurality of contact blocks and contacts the at least one contact via, where each of the plurality of contact blocks includes a side surface that respectively contacts sidewalls of the plurality of dielectric isolation patterns, and an interconnection structure that is on lower surfaces of the plurality of contact blocks, is on the plurality of dielectric isolation patterns, is on the device isolation layer, and is electrically connected to the at least one contact block.

According to another aspect of the present disclosure, a semiconductor device includes: a semiconductor pattern that extends in a first direction, a device isolation layer that is on opposing side surfaces of the semiconductor pattern and extends in the first direction, a plurality of channel structures that are spaced apart from each other in the first direction and are on the semiconductor pattern, a plurality of gate structures that are on the plurality of channel structures and extend in a second direction that intersects the first direction, a first source/drain pattern and a second source/drain pattern that are on the semiconductor pattern, an interlayer insulating layer that is on the device isolation layer and extends around the plurality of gate structures, the first source/drain pattern, and the second source/drain pattern, a dielectric isolation layer on a lower surface of the semiconductor pattern, a plurality of dielectric isolation patterns that extend in a third direction toward the plurality of gate structures and into the dielectric isolation layer, where the third direction is perpendicular to the first direction, an upper contact that is electrically connected to the first source/drain pattern and extends into the interlayer insulating layer, a plurality of contact blocks that are respectively between adjacent ones of the plurality of dielectric isolation patterns and are on the lower surface of the dielectric isolation layer, a contact via that extends from a first contact block of the plurality of contact blocks that is adjacent to the second source/drain pattern to the second source/drain pattern and extends into the dielectric isolation layer, a conductive barrier that is between the dielectric isolation layer and the plurality of contact blocks and contacts the contact via, where each of the plurality of contact blocks includes a side surface that respectively contacts sidewalls of the plurality of dielectric isolation patterns, a first interconnection structure that is on the interlayer insulating layer and is electrically connected to the upper contact, and a second interconnection structure that is on lower surfaces of the plurality of contact blocks, is on the plurality of dielectric isolation patterns, is on the device isolation layer, and is electrically connected to the first contact block.

At least some of the above and other features of the invention are set out in the claims.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a plan view illustrating a semiconductor device according to an embodiment of the present disclosure;
FIG. 2 is a cross-sectional view taken along line I-I' of the semiconductor device of FIG. 1;
FIG. 3A and FIG. 3B are cross-sectional views taken along lines II1-II1' and II2-II2' of the semiconductor device of FIG. 1, respectively;
FIG. 4A is a partially enlarged view of portion "A1" of the semiconductor device of FIG. 2, and FIG. 4B is a partially enlarged view of portion "B" of the semiconductor device of FIG. 3A;
FIGS. 5 and 6 are cross-sectional views illustrating a semiconductor device according to an embodiment of the present disclosure;
FIG. 7 is a partially enlarged view of portion "A2" of the semiconductor device of FIG. 5;
FIGS. 8A, 8B, 8C, 8D, 8E, and 8F are cross-sectional views illustrating example dielectric isolation pattern forming processes of a method for manufacturing a semiconductor device according to an embodiment of the present disclosure;
FIGS. 9A, 9B, 9C, and 9D are side views corresponding to the semiconductor device of FIGS. 8A, 8B, 8C, and 8F, respectively;
FIGS. 10A, 10B, 10C, and 10D are cross-sectional views illustrating example back contact forming processes of a method for manufacturing a semiconductor device according to an embodiment of the present disclosure; and
FIGS. 11A, 11B, 11C, and 11D are side views corresponding to the semiconductor device of FIGS. 10A to 10D, respectively.

### DETAILED DESCRIPTION

To clarify the present disclosure, the same elements or equivalents are referred to by the same reference numerals throughout the specification. Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., are exaggerated for clarity. In the drawings, for better understanding and ease of description, thicknesses of some layers and areas are excessively displayed.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, spatially relative terms, such as "beneath," "below," "lower," "above," "upper," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

In addition, unless explicitly described to the contrary, the word "comprises", and variations such as "comprises" or "comprising", will be understood to imply the inclusion of stated elements but not the exclusion of any other elements. As used herein, the singular forms "a," "an" and "the" are intended to include the plural forms as well, unless the context clearly indicates otherwise. The term "and/or" includes any and all combinations of one or more of the associated listed items. The term "connected" may be used herein to refer to a physical and/or electrical connection and may refer to a direct or indirect physical and/or electrical connection. The term "exposed" may be used to define a relationship between particular layers or surfaces, but it does not require the layer or surface to be free of other elements or layers thereon in the completed device. Components or layers described with reference to "overlap" in a particular direction may be at least partially obstructed by one another when viewed along a line extending in the particular direction or in a plane perpendicular to the particular direction. The terms "first," "second," etc. may be used herein to merely distinguish one component, element, etc., from another.

Hereinafter, various embodiments of the present disclosure will be described in detail with reference to the accompanying drawings.

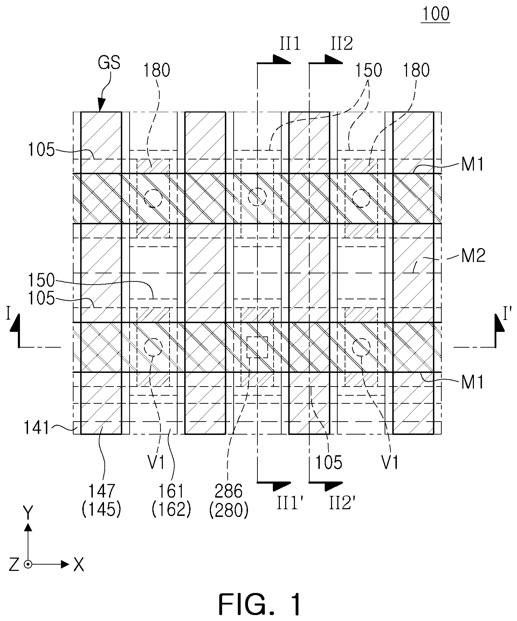

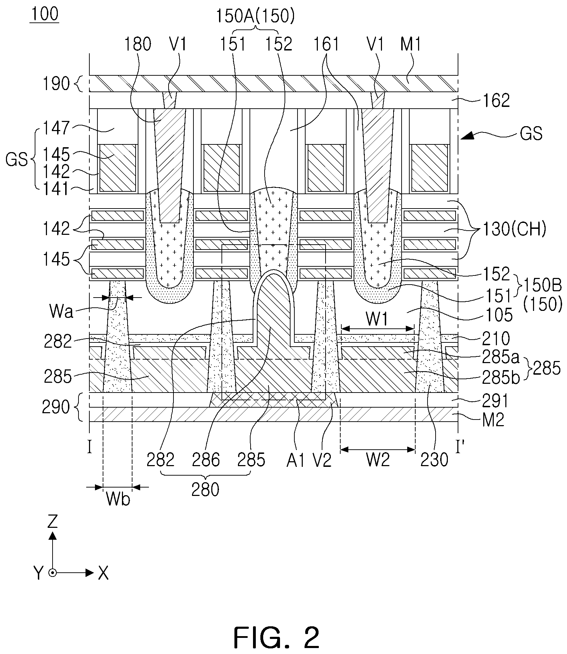

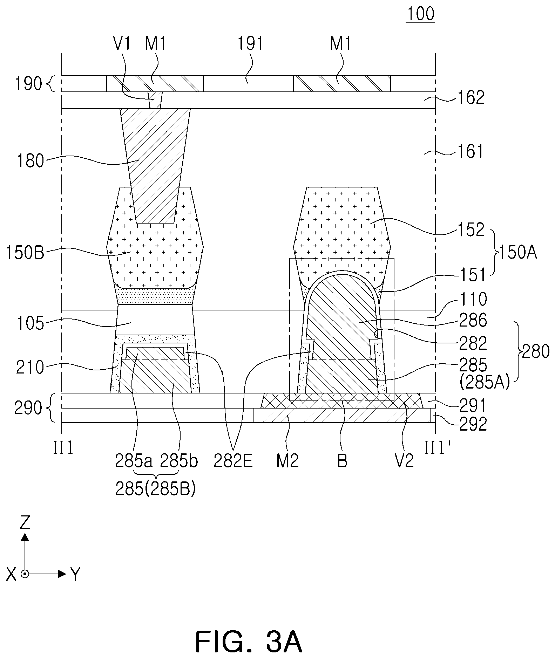

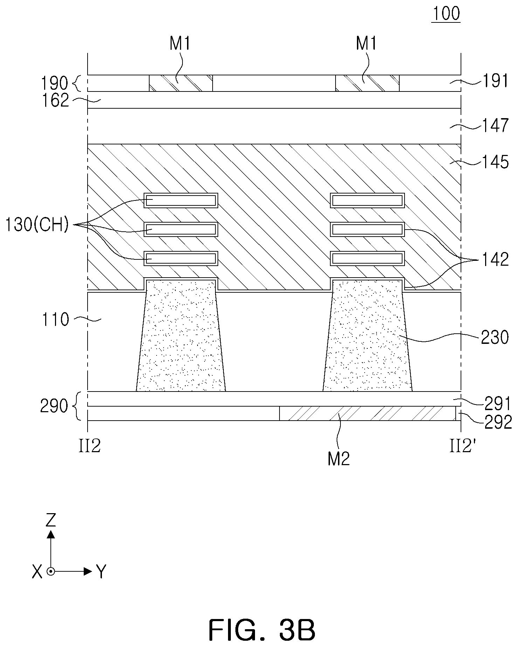

FIG. 1 is a plan view illustrating a semiconductor device according to an embodiment of the present disclosure, FIG. 2 is a cross-sectional view taken along line I-I' of the semiconductor device of FIG. 1, and FIGS. 3A and 3B are cross-sectional views taken along lines II1-II1' and II2-II2' of the semiconductor device of FIG. 1, respectively.

Referring to FIGS. 1, 2, 3A and 3B, a semiconductor device 100 according to some embodiments may include a semiconductor pattern 105 extending in a first direction (e.g., an X-direction), a plurality of channel structures CH arranged to be spaced apart from each other in the first direction (e.g., the X-direction) on the semiconductor pattern 105, a plurality of gate structures GS crossing or on the plurality of channel structures CH and extending in a second direction (e.g., a Y direction) intersecting the first direction (e.g., the X-direction), and source/drain patterns 150 arranged between the plurality of channel structures CH. The first direction and the second direction may define a horizontal plane. The first direction may be perpendicular to the second direction. A vertical direction (e.g. a Z-direction) may be perpendicular to the first direction and the second direction. The vertical direction may be a height direction. Elements that are described as being "above" other elements may be located further along the vertical direction than the other elements. Similarly, "upper" portions of elements may be above "lower" portions of elements. It will be appreciated that these directions and positions are defined relative to the structure of the device and therefore need not imply any particular orientation of the device in use.

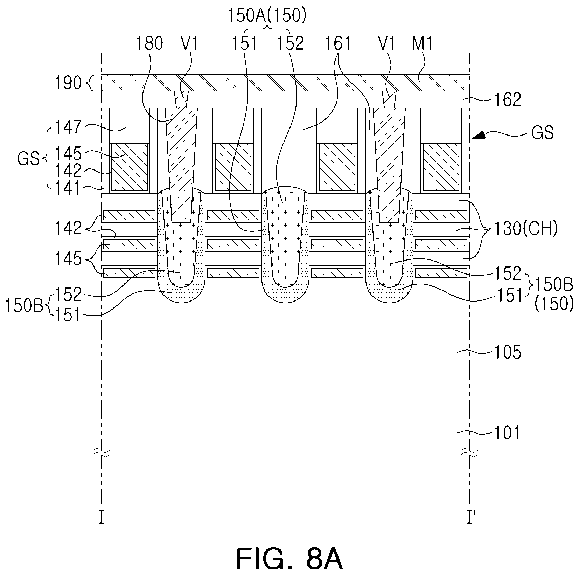

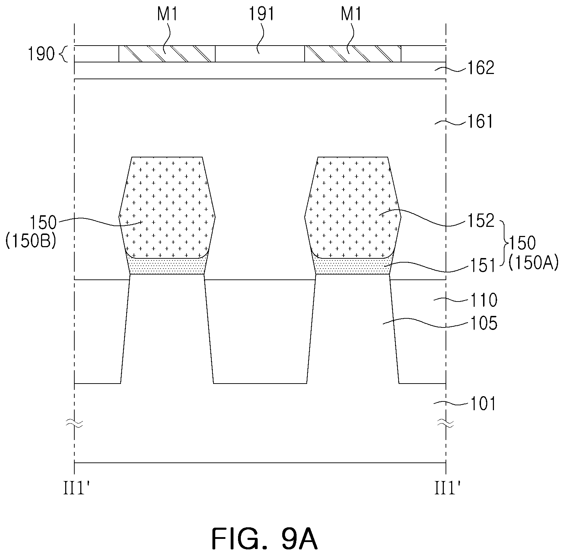

The semiconductor device 100 according to some embodiments may include, as a base structure, the semiconductor pattern 105 disposed on the lower surfaces of the gate structures GS and the first and second source/drain patterns 150A and 150B. In some embodiments, the semiconductor pattern 105 may be a portion of an "active pattern" protruding or extending from a substrate 101 and extending in the first direction (e.g., the X-direction) before grinding the substrate 101 (see FIGS. 8A and 9A).

Referring to FIG. 3A, a device isolation layer 110 may be disposed between the semiconductor patterns 105. The device isolation layer 110 may be disposed on opposing side surfaces of the semiconductor patterns 105 extending in the first direction. An upper region of the semiconductor pattern 105 may be exposed from an upper surface of the device isolation layer 110.

As illustrated in FIGS. 2 and 3B, the channel structures CH may be arranged at regular intervals in the first direction (e.g., the X-direction) on the semiconductor pattern 105. In some embodiments, the channel structure CH may include a plurality of channel patterns 130 stacked and spaced apart from each other in the vertical direction (e.g., in a Z-direction) on the semiconductor pattern 105. The plurality of channel patterns 130 are provided as a channel structure of a transistor and may include, for example, at least one of silicon (Si), silicon germanium (SiGe), and germanium (Ge). In some embodiments, the plurality of channel patterns 130 may be silicon semiconductors. In some embodiments, the plurality of channel patterns 130 include three channel patterns 130, but the number and shape thereof may vary.

As illustrated in FIGS. 1, 2, and 3B, the gate structure GS may include a gate electrode 145 extending in the second direction (e.g., the Y-direction) and surrounding or extending around the plurality of channel patterns 130, a gate insulating film 142 disposed between the gate electrode 145 and the plurality of channel patterns 130, gate spacers 141 disposed on opposing side surfaces of the gate electrode 145 portion positioned on the uppermost channel pattern, and a gate capping layer 147 disposed on the gate electrode 145 between the gate spacers 141.

The gate electrode 145 may include a conductive material. For example, the gate electrode 145 may include at least one of tungsten (W), titanium (Ti), tantalum (Ta), molybdenum (Mo), titanium nitride (TiN), tantalum nitride (TaN), tungsten nitride (WN), titanium oxynitride (TiON), titanium aluminum carbide (TiAlC), titanium aluminum nitride (TiAlN), and tantalum aluminum carbide (TaAlC). In some embodiments, the gate electrode 145 may include a semiconductor material, such as doped polysilicon. At least one of the gate electrodes 145 may include a multilayer structure including different materials.

The gate insulating film 142 may include a dielectric material. For example, the gate insulating film 142 may include an oxide, a nitride, or a high-k material. The high-k material refers to a dielectric material having a higher dielectric constant than that of silicon oxide (SiO₂), and the high-k material may be, for example, one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃). In some embodiments, the gate insulating film 142 may include two or more different dielectric films.

The gate spacers 141 may include an insulating material. For example, the gate spacers 141 may include at least one of silicon oxide, silicon nitride, and silicon oxynitride. In some embodiments, the gate spacers 141 may include a multilayer structure including different materials. The gate capping layer 147 may include, for example, silicon nitride, silicon oxynitride, silicon carbonitride, or silicon oxycarbonitride.

Referring to FIG. 2, the semiconductor device 100 according to some embodiments may include source/drain patterns 150 respectively connected to opposing sides of the plurality of channel patterns 130 (e.g. channel regions), on opposing sides of the gate structures GS. In some embodiments, the semiconductor patterns 105 portion located on opposing sides of the gate structures GS have recessed regions, and the source/drain patterns 150 may be arranged in the recessed regions of the semiconductor patterns 105.

Referring to FIGS. 2 and 3A, the source/drain patterns 150 employed in some embodiments include a first epitaxial layer 151 and a second epitaxial layer 152 disposed on the first epitaxial layer 151. In some embodiments, the first epitaxial layer 151 may directly contact side surfaces of the plurality of channel patterns 130. In some embodiments, the first epitaxial layer 151 and the second epitaxial layer 152 may include different materials. For example, in the case of a P-type MOSFET, the first and second epitaxial layers 151 and 152 may include SiGe having different Ge compositions (e.g., the second epitaxial layer 152 may have a higher Ge content), or the first and second epitaxial layers 151 and 152 may include Si and SiGe, respectively. In some embodiments, the first epitaxial layer 151 and the second epitaxial layer 152 may include different types of impurities or the same impurities at different concentrations. In the case of an N-type MOSFET, the first and second epitaxial layers 151 and 152 may both include Si, but the first epitaxial layer 151 and the second epitaxial layer 152 may include different types of impurities or the same impurities at different concentrations.

The semiconductor device 100 according to some embodiments may include an upper contact structure 180 connected to a first interconnection structure 190 on the front side and a lower contact structure 280 connected to a second interconnection structure 290 on the back side. For example, the first interconnection structure 190 may include a signal line connected to the second source/drain patterns 150B of the semiconductor device 100 through the upper contact structure 180, and the second interconnection structure 290 may include a power line connected to the first source/drain patterns 150A of the semiconductor device 100 through the lower contact structure 280.

In some embodiments, the upper contact structure 180 may be connected to the second source/drain patterns 150B between adjacent gate structures GS, and the lower contact structure 280 may be connected to the first source/drain patterns 150A between adjacent dielectric isolation patterns 230. Hereinafter, the upper and lower contact structures will be described in more detail.

The semiconductor device 100 according to some embodiments may further include a first interlayer insulating layer 161 disposed on the device isolation layer 110 to cover or at least partially overlap the source/drain patterns 150, i.e., the first and second source/drain patterns 150A and 150B, and a second interlayer insulating layer 162 covering or at least partially overlapping the gate structure GS on the first interlayer insulating layer 161, as illustrated in FIGS. 2 and 3B. For example, the first and second interlayer insulating layers 161 and 162 may include spin-on hardmask (SOH), flowable oxide (FOX), tonen silazen (TOSZ), undoped silica glass (USG), borosilica glass (BSG), phosphosilaca glass (PSG), borophosphosilica glass (BPSG), plasma enhanced tetra ethyl ortho silicate (PETEOS), fluoride silicate glass (FSG), high density plasma (HDP) oxide, plasma enhanced oxide (PEOX), flowable CVD (FCVD) oxide, or combinations thereof. The first and second interlayer insulating layers 161 and 162 may be formed using chemical vapor deposition, a flowable CVD process, or a spin-coating process.

In some embodiments, the upper contact structure 180 may be connected to the second source/drain pattern 150B through the first interlayer insulating layer 161. The upper contact structure 180 may extend from an upper surface of the second source/drain pattern 150B into the interior thereof.

The upper contact structures 180 may each include a contact plug and a conductive barrier surrounding or extending around the contact plug. For example, the contact plug may include copper (Cu), cobalt (Co), molybdenum (Mo), ruthenium (Ru), tungsten (W), or an alloy thereof. For example, the conductive barrier may include tantalum (Ta), tantalum nitride (TaN), manganese (Mn), manganese nitride (MnN), tungsten nitride (WN), titanium (Ti), titanium nitride (TiN), or combinations thereof.

As illustrated in FIG. 2, a dielectric isolation layer 210 may be disposed on a lower surface of the semiconductor pattern 105. A plurality of dielectric isolation patterns 230 may be respectively disposed in regions corresponding to the plurality of gate structures GS on a lower surface of a dielectric isolation layer 210. The plurality of dielectric isolation patterns 230 may have a structure extending in the vertical direction (e.g., in the Z-direction). The plurality of dielectric isolation patterns 230 may define spaces for contact blocks 285 on a lower surface of the dielectric isolation layer 210. Each of the plurality of dielectric isolation patterns 230 may extend through or into the dielectric isolation layer 210 toward each of the plurality of gate structures GS. The semiconductor pattern 105 may be separated into a plurality of patterns by the extended portions of the dielectric isolation patterns 230. As an example, at least one of the dielectric isolation layer 210 and the dielectric isolation patterns 230 may include silicon nitride, silicon oxynitride, aluminum nitride, or aluminum oxynitride. In some embodiments, the dielectric isolation layer 210 and the dielectric isolation patterns 230 may include the same insulating material.

A plurality of contact blocks 285 may be arranged in the space between the plurality of dielectric isolation patterns 230 on a lower surface of the dielectric isolation layer 210. The plurality of contact blocks 285 may each be positioned below the source/drain patterns 150 and may be utilized as a portion of a potential lower contact structure for the corresponding source/drain pattern 150. As to be described below, in some embodiments, the contact block 285 may be utilized as the lower contact structure 280 together with a contact via 286 extending therefrom. The contact block 285 employed in some embodiments may be separately referred to as an 'active contact block 285A' participating in the operation of the transistor and 'dummy contact blocks 285B' not participating in the operation of the transistor.

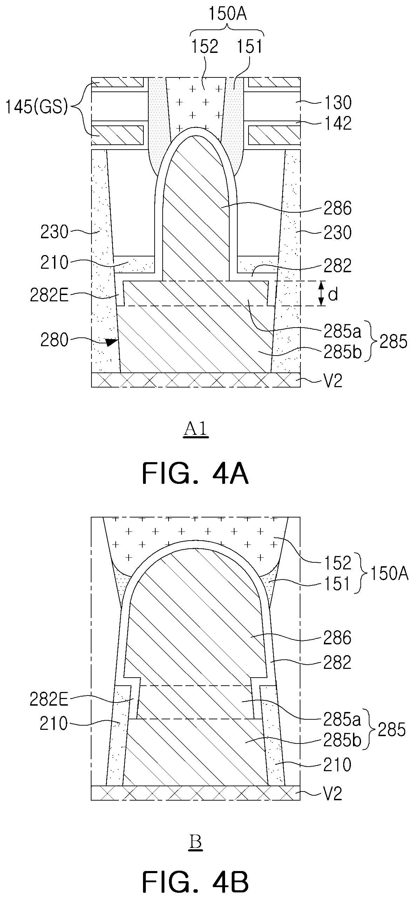

The lower contact structure 280 employed in some embodiments may include at least one contact block 285A among the contact blocks 285 and a contact via 286 extending from the at least one contact block 285A to the first source/drain pattern 150A. The contact via 286 may extend from the at least one contact block 285A through the dielectric isolation layer 210 to an adjacent first source/drain pattern 150A among the source/drain patterns 150. The contact via 286 may be connected to the second epitaxial layer 152 by passing or extending through the first epitaxial layer 151 to lower the contact resistance (see FIG. 4A).

In some embodiments, in a cross-section (see FIG. 2) of the semiconductor device 100 in the first direction, each of the plurality of dielectric isolation patterns 230 may have a shape in which a width Wb of a portion adjacent to the second interconnection structure 290 is greater than a width Wa of a portion adjacent to the plurality of gate structures GS. For instance, each of the plurality of dielectric isolation patterns 230 may have a shape in which the width in the first direction decreases as the dielectric isolation pattern 230 extends in the third direction. This is because an etching process for the dielectric isolation patterns 230 is performed at a relatively low temperature (e.g., 400°C or less) not to adversely affect a metal component of the first interconnection structure 190, and thus, the plurality of dielectric isolation patterns 230 may each have a tapered structure. Accordingly, each of the contact blocks 285 defined by the plurality of dielectric isolation patterns 230 may have a shape in which the width W2 of the portion adjacent to the second interconnection structure 290 is less than the width W1 of the portion adjacent to the dielectric isolation layer 210.

The semiconductor device 100 employed in some embodiments may further include a conductive barrier 282 disposed between the dielectric isolation layer 210 and the plurality of contact blocks 285. In the lower contact structure 280, the conductive barrier 282 may extend to a surface of at least one contact via 286. There is a portion on a side surface of the contact blocks 285 in which the conductive barrier 282 does not extend. Each of the plurality of contact blocks 285 may have a side surface portion contacting sidewalls of the plurality of dielectric isolation patterns 230 (for example, adjacent or mutually adjacent dielectric isolation patterns 230). For instance, each of the plurality of contact blocks 285 might have opposite sidewalls (e.g. sidewalls in the first direction) that contact adjacent dielectric isolation patterns 230.

FIG. 4A is a partially enlarged view of portion "A1" of the semiconductor device of FIG. 2, and FIG. 4B is a partially enlarged view of portion "B" of the semiconductor device of FIG. 3A.

Referring to FIGS. 4A and 4B together with FIGS. 2 and 3A, the conductive barrier 282 may have a portion (i.e., an extended portion) 282E extending from the sidewalls of the plurality of dielectric isolation patterns 230 to a portion adjacent to the dielectric isolation layer 210. Based on the extended portion 282E of the conductive barrier 282, each of the plurality of contact blocks 285 may be divided or partitioned into two portions 285a and 285b. Each of the plurality of contact blocks 285 may include a first portion 285a overlapping the extended portion 282E in a horizontal direction and a second portion 285b contacting the plurality of dielectric isolation patterns 230 (for example, adjacent or mutually adjacent dielectric isolation patterns 230). The extended portion 282E may extend from the second portion 285b (e.g. from an upper surface of the second portion 285b) to the dielectric isolation layer 210 (e.g. a lower surface of the dielectric isolation layer 210). The extended portion 282E may extend along the sidewalls of the adjacent dielectric isolation patterns 230. The extended portion 282E may be located between the first portion 285b and the adjacent dielectric isolation patterns 230. The extended portion 282E may extend at least partially in the third direction (e.g. the extended portion 282E may extend in a direction that has a component in the third direction). For example, the extended portion 282E may extend in directions parallel to the sidewalls of the adjacent dielectric isolation patterns 230.

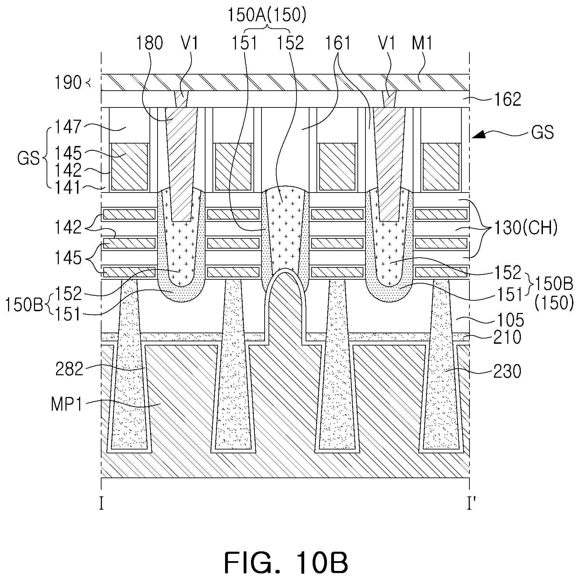

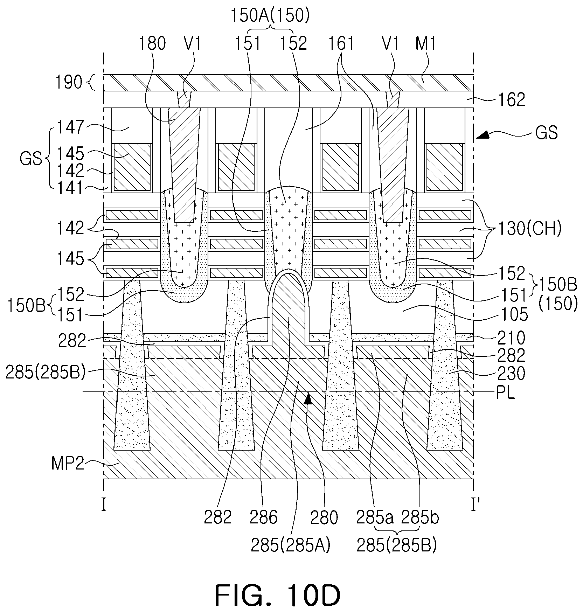

In some embodiments, the first portion 285a and the second portion 285b of the contact block 285 may include the same metal material. However, the first portion 285a and the second portion 285b may be formed by different deposition processes (see FIGS. 10B and 10D). The first portion 285a may be used as a seed layer in the deposition process for the second portion 285b. The plurality of contact blocks 285, particularly, the second portion 285b, may include a metal having a substantially single-crystal structure without grain boundaries. For example, the first portion 285a may be performed by a non-selective deposition process, for example, a physical vapor deposition (PVD) or chemical vapor deposition (CVD), and the second portion 285b may be performed by a selective deposition process, e.g., a selective CVD process or an atomic layer deposition (ALD) process.

In some embodiments, a thickness of the first portion 285a may be based on the extended portion 282E of the conductive barrier 282. The first portion 285a may have an appropriate thickness for the seed layer. For example, a length d (e.g., in a third direction (the Z-direction)) of the extended portion 282E may be 1 nm or more, but is not limited thereto.

In some embodiments, the contact via 286 may include the same metal material as that of the first portion 285a of the plurality of contact blocks 285. Each of the plurality of contact blocks 285 may include the same metal material as that of the contact via 286.

In some embodiments, the contact via and the contact block may include molybdenum (Mo) or tungsten (W). For example, when forming the contact block 285 using molybdenum, voids may occur. For example, the conductive barrier 282 may include Ta, TaN, Mn, MnN, WN, Ti, TiN, or combinations thereof.

The lower contact structure 280 adopted in some embodiments may not only form the high-quality contact block 285A, but also replace the conductive barrier 282 having a relatively high resistance with the material of the contact block 285A. Therefore, the lower contact structure 280 may improve electrical characteristics of the semiconductor device 100, such as reducing the contact resistance and improving the reliability. In some embodiments, the lower contact structure 280 may have a sufficient length to sufficiently remove the conductive barrier. For example, the length d of the extended portion 282E may be 10 nm or less, but is not limited thereto.

The semiconductor device 100 according to some embodiments may have a double-sided interconnection structure including a first interconnection structure 190 and a second interconnection structure 290. The first interconnection structure 190 may be provided on an upper surface of the semiconductor device 100, and the second interconnection structure 290 may be provided on a lower surface of the semiconductor device 100.

The first interconnection structure 190 may include a first interconnection insulating layer 191 and a first interconnection line M1 disposed within the first interconnection insulating layer 191. The first interconnection line M1 may be connected to the upper contact structure 180 by a first via V1 penetrating or extending into the second interlayer insulating layer 162.

Similarly, the second interconnection structure 290 may include second interconnection insulating layers 291 and 292 and a second via V2 and a second interconnection line M2 disposed in the second interconnection insulating layers 291 and 292. In some embodiments, the second interconnection line M2 may be electrically insulated from the dummy contact block 285B by the second interconnection insulating layer 291, while being connected to the active contact block 285A of the lower contact structure 280 by the second via V2 penetrating or extending into the second interconnection insulating layer 291.

In some embodiments, power for a device operation may be supplied to the first source/drain pattern 150A through the second interconnection line M2 and the lower contact structure 280 connected thereto, thereby simplifying the first interconnection line M1.

As an example, the first and second interconnection insulating layers 191, 291, and 292 may include a low-k material, such as silicon oxide, silicon oxynitride, SiOC, or SiCOH. As an example, the first and second interconnection lines M1 and M2 and the first and second vias V1 and V2 may include copper or a copper-containing alloy.

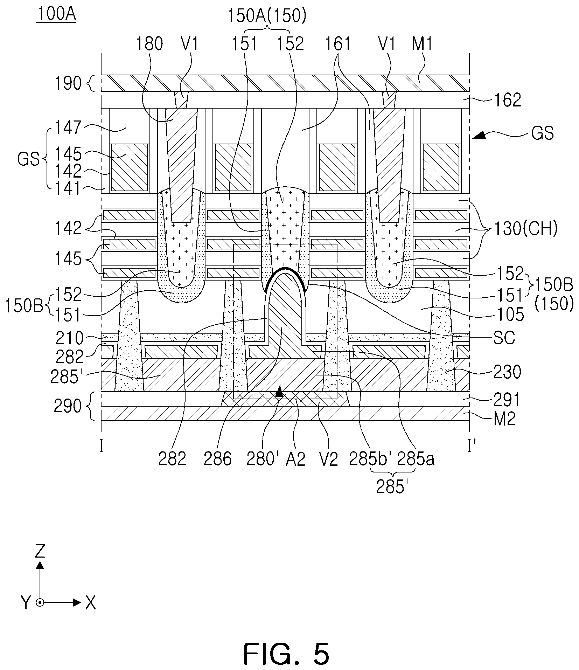

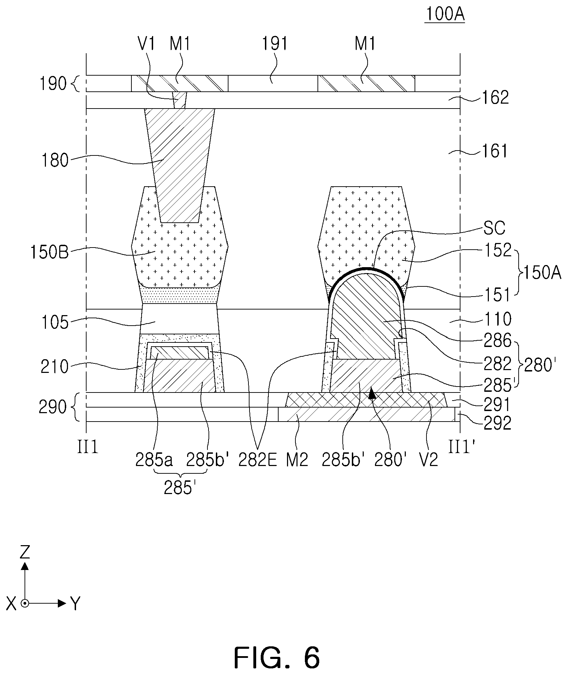

FIGS. 5 and 6 are cross-sectional views illustrating a semiconductor device according to an embodiment of the present disclosure.

Referring to FIGS. 5 and 6, a semiconductor device 100A according to some embodiments may be understood as being similar to the semiconductor device 100 illustrated in FIGS. 1 to 4B, except that a lower contact structure 280' includes different metal materials and that a metal-semiconductor compound film SC is provided between the contact via 286 and the first source/drain pattern 150A. In addition, the components may be understood by referring to the description of the same or similar components of the semiconductor device 100 illustrated in FIGS. 1 to 4B, unless otherwise specifically described.

Similar to the semiconductor device 100, each of the plurality of contact blocks 285' employed in some embodiments may include a first portion 285a horizontally overlapping the extended portion 282E of the conductive barrier 282 and a second portion 285b' contacting the plurality of dielectric isolation patterns 230. However, in some embodiments, the first portion 285a may include a first metal material, and the second portion 285b' may include a second metal material, different from the first metal material.

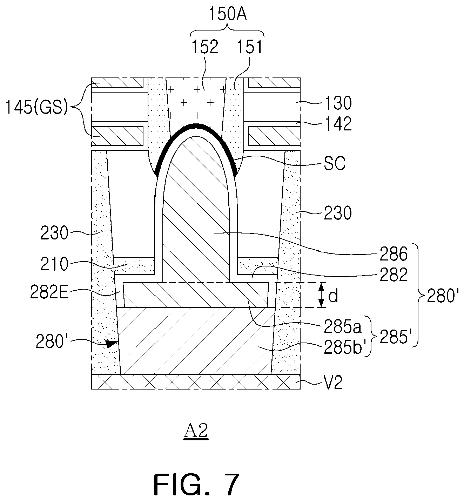

FIG. 7 is an enlarged view of portion "A2" of the semiconductor device of FIG. 5.

Referring to FIGS. 5 to 7, in some embodiments, the first portion 285a and the second portion 285b' of the contact block 285' may include different first and second metal materials, respectively. For example, the first metal material may include W, Mo, Co, or Ru, and the second metal material may include W or Mo. Since the first and second metal materials have the same or similar crystal structures, even if the first and second portions 285a and 285b' are different metals, the first portion 285a may be used as a seed layer for the second portion 285b'. In addition, in some embodiments, the second portion 285b' of the contact blocks 285' may include a metal having an almost (or substantially) single crystal structure without grain boundaries. For example, the first portion 285a may be formed by a non-selective deposition process, for example, PVD or CVD, and the second portion 285b' may be formed by a selective deposition process, for example, a selective CVD process or an ALD process.

In some embodiments, the distance by which the extended portion 282E of the conductive barrier 282 extends may be relatively reduced in the range of providing the seed layer to improve or reduce the resistance. For example, the length d of the extended portion 282E may be 1 nm to 10 nm, but is not limited thereto.

In this manner, the lower contact structure 280' employed in some embodiments may not only form a high-quality second portion 285b', but may also replace the conductive barrier 282 having relatively high resistance with the material of the contact block 285'. Therefore, the lower contact structure 280' may improve electrical characteristics of the semiconductor device 100A, such as reducing the contact resistance and improving the reliability.

In some embodiments, the metal-semiconductor compound film SC may be disposed between the contact via 286 and the first source/drain pattern 150A. Referring to FIG. 5, the metal-semiconductor compound film SC may extend toward a surface region of the semiconductor pattern 105 contacting the contact via 286. The metal-semiconductor compound film SC may include metal-silicide. For example, the metal-semiconductor compound film SC may include at least one metal among Ti, Co, nickel (Ni), platinum (Pt), zirconium (Zr), Mo, and scandium (Sc).

The features, functions, and effects of the embodiments may be understood in more detail while describing the method for manufacturing a semiconductor device below.

FIGS. 8A to 8F and FIGS. 9A to 9D are cross-sectional views illustrating major processes of some processes of the method for manufacturing a semiconductor device according to an embodiment of the present disclosure and may be understood as processes for manufacturing the semiconductor device 100 illustrated in FIGS. 1 to 4B.

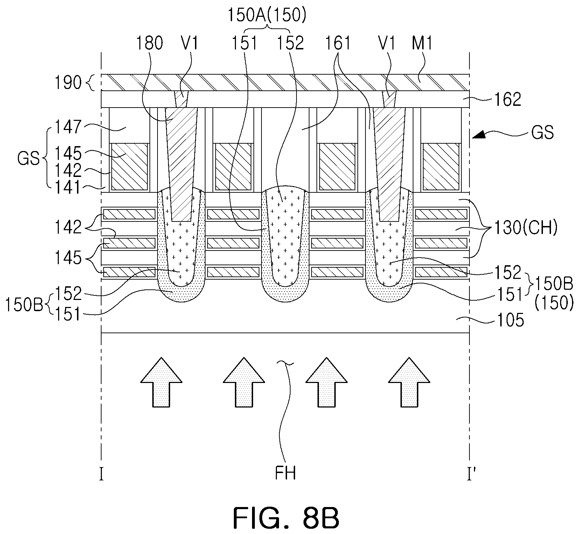

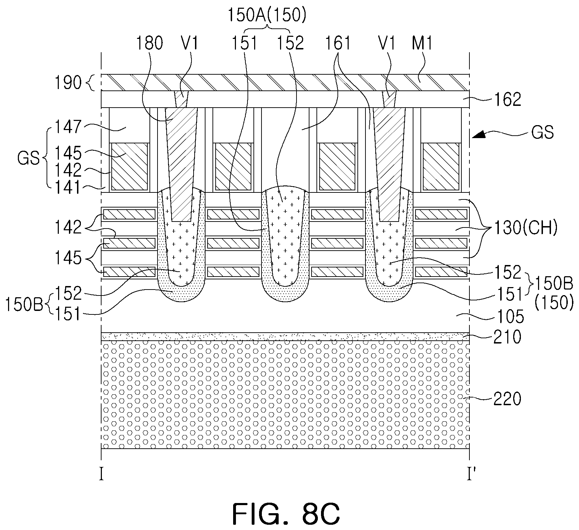

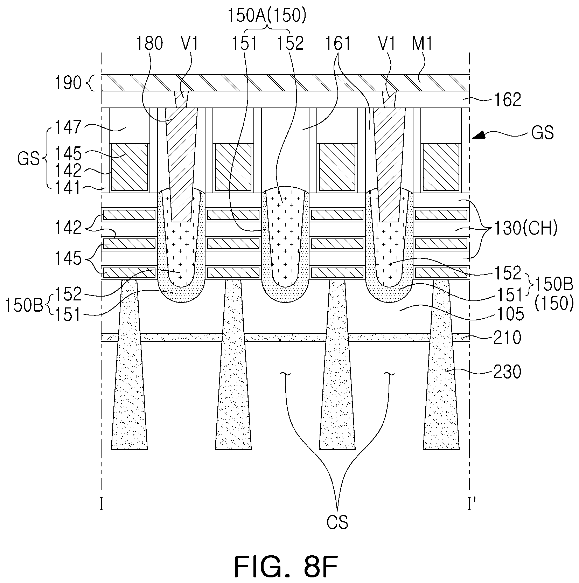

Here, FIGS. 8A to 8F are cross-sectional views corresponding to FIG. 2, respectively, and FIGS. 9A to 9D are cross-sectional views corresponding to FIG. 3A and represent the processes of FIGS. 8A, 8B, 8C, and 8F, respectively.

Referring to FIGS. 8A and 9A, gate all around-type transistor devices including a plurality of channel structures CH, a plurality of gate structures GS, and first and second source/drain patterns 150A and 150B may be formed on a substrate 101.

The substrate 101 may include a semiconductor material, for example, a group IV semiconductor, a group III-V compound semiconductor, or a group II-VI semiconductor. For example, the group IV semiconductor may include silicon (Si), germanium (Ge), or silicon germanium (SiGe). The substrate 101 may include a bulk wafer, an epitaxial layer, or a silicon on insulator (SOI) layer.

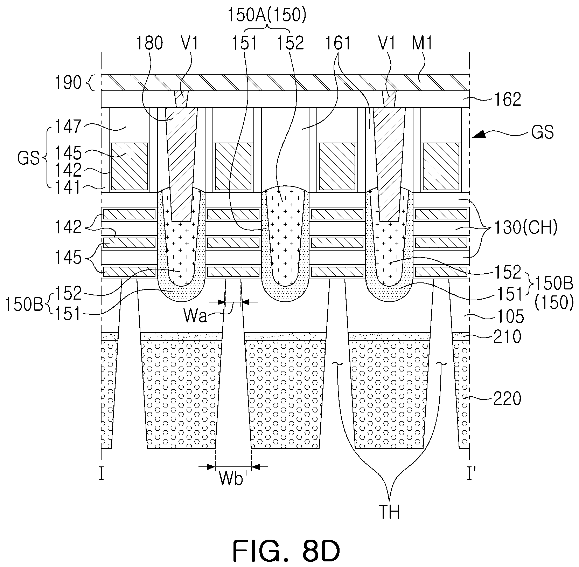

The plurality of channel structures CH may include a plurality of channel patterns 130 stacked and spaced apart from each other in a direction (e.g., the third direction (e.g., the Z-direction)) perpendicular to the first direction (e.g., the X-direction) on the semiconductor pattern 105 extending in the first direction (e.g., the X-direction). The plurality of gate structures GS may be formed to surround or extend around the plurality of channel patterns 130 while crossing the plurality of channel structures CH in the second direction (e.g., the Y-direction). The first and second source/drain patterns 150A and 150B may be arranged in a recess region extending between the plurality of channel structures CH into a portion of the semiconductor pattern 105 and may be connected to opposing side surfaces of the plurality of channel patterns 130 in the first direction (e.g., the X-direction), respectively. In addition, a first interlayer insulating layer 161 covering or at least partially overlapping the first and second source/drain patterns 150A and 150B may be formed between the plurality of gate structures GS, and an upper contact structure 180 connected to the first source/drain pattern 150A may be formed by penetrating the first interlayer insulating layer 161. Furthermore, a second interlayer insulating layer 162 may be formed on the first interlayer insulating layer 161 to cover or at least partially overlap the plurality of gate structures GS, and a first interconnection structure 190 connected to the upper contact structure 180 may be formed. Since the first interconnection structure is formed in advance, there may be a limitation that a subsequent process may need to be performed at a relatively low temperature (e.g., 400°C or less) to not adversely affect the metal component of the first interconnection structure 190. For example, along with the process of forming the first opening TH for the dielectric isolation pattern (see FIG. 8D), forming a conductive barrier with a sufficient thickness (see FIG. 10B) may be desirable to prevent pin hole defects.

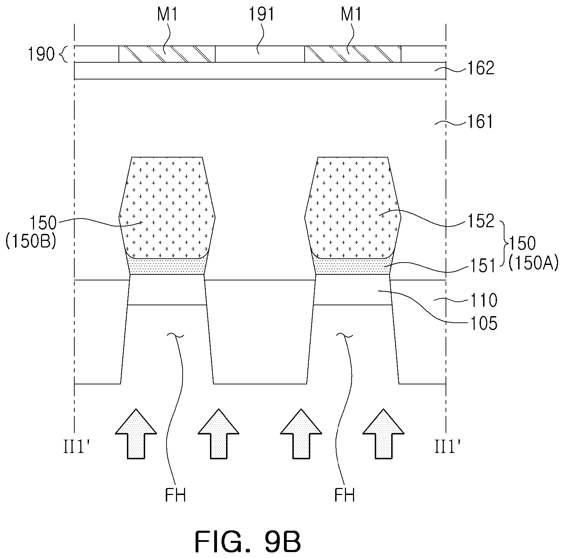

Thereafter, referring to FIGS. 8B and 9B, the substrate 101 may be removed to partially leave or expose the semiconductor pattern 105.

This process may be sequentially performed as a process of removing the substrate 101 and a process of partially removing the semiconductor pattern 105. First, the process of removing the substrate 101 may be performed by a polishing process and/or an etching process. The removal process may be performed until the device isolation layer 110 is exposed. In addition, the semiconductor pattern 105 having a predetermined thickness may remain by partially removing the semiconductor pattern 105 using a selective etching process. The remaining semiconductor pattern 105 may extend in the first direction and may have a recessed lower surface relative to the exposed lower surface of the device isolation layer 110, as shown in FIG. 9B. The device isolation layer 110 may define a space FH from which the semiconductor pattern 105 was removed.

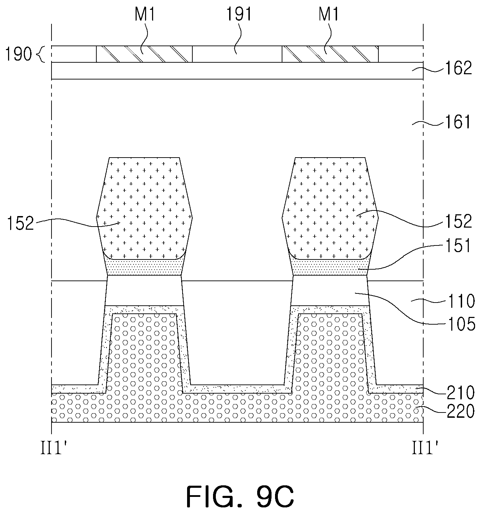

Next, referring to FIGS. 8C and 9C, the dielectric isolation layer 210 may be formed on the lower surface of the remaining semiconductor pattern 105, and a dielectric base layer 220 may be formed on the dielectric isolation layer 210.

First, the dielectric isolation layer 210 may be formed on the semiconductor pattern 105 and the device isolation layer 110. As shown in FIG. 9C, the dielectric isolation layer 210 may be formed on the recessed lower surface of the semiconductor pattern 105, the sidewall at least partially exposed to the space FH, and the lower surface of the device isolation layer 110. The dielectric isolation layer 210 may be formed conformally on the semiconductor pattern 105 and the device isolation layer 110 using a deposition process, such as CVD. As an example, the dielectric isolation layer 210 may include silicon nitride, silicon oxynitride, aluminum nitride, aluminum oxide, or aluminum oxynitride.

The dielectric base layer 220 may be formed to at least partially fill the space FH from which the semiconductor pattern 105 was partially removed on the dielectric isolation layer 210. The dielectric base layer 220 may include, for example, SOH, FOX, TOSZ, USG, BSG, PSG, BPSG, PETEOS, FSG, HDP oxide, PEOX, FCVD oxide, or combinations thereof. For example, the dielectric base layer 220 may each be formed using CVD, a fluidized CVD process, or a spin-coating process. In some embodiments, a planarization process may be additionally performed on the lower surface of the dielectric base layer 220.

Next, referring to FIG. 8D, a plurality of first openings TH may be formed by partially removing the dielectric base layer 220 and the dielectric isolation layer 210.

A plurality of first openings TH may be formed in regions respectively corresponding to the plurality of gate structures GS in the dielectric base layer 220 using a selective etching process. Each of the first openings TH may align with a respective gate structure GS in the third direction. The plurality of first openings TH may extend through the dielectric isolation layer 210 to the gate structures GS. In some embodiments, the semiconductor pattern 105 may be formed as a plurality of portions separated by the plurality of first openings TH.

Because the etching process for the plurality of first openings TH is performed at a relatively low temperature (e.g., 400°C or less) so as not to adversely affect the metal component of the first interconnection structure 190, it may be difficult to form the plurality of first openings TH to have an almost vertical structure. Therefore, the first openings TH may have a tapered structure. As illustrated in FIG. 8D, each of the plurality of first openings TH may have a shape in which a width Wb' of a portion adjacent to the lower surface of the dielectric base layer 220 is greater than a width Wa of a portion adjacent to the plurality of gate structures GS. In addition, due to a difference in etching rates, an inner sidewall of the semiconductor pattern 105 and an inner sidewall of the dielectric base layer 220 may have different profiles (e.g., inclination angles).

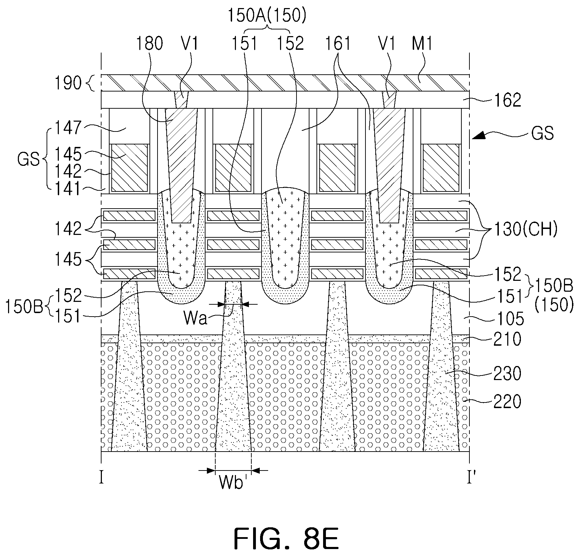

Next, referring to FIG. 8E, dielectric isolation patterns 230 may be formed in of the plurality of first openings TH, respectively.

In some embodiments, a deposition process may be performed to form the dielectric isolation patterns 230 in the plurality of first openings TH. The first openings TH may be at least partially filled during a deposition process of an insulating material. For example, the dielectric isolation patterns 230 may include silicon nitride or silicon oxynitride. In the insulating material deposition process of forming the plurality of dielectric isolation patterns 230, they are formed to cover or at least partially overlap the lower surface of the dielectric base layer 220, and in addition, through a polishing process, as shown in FIG. 8E, the lower surface of the dielectric base layer 220 may be at least partially exposed and may have a substantially flat surface that is coplanar with the lower surface of the dielectric isolation patterns 230.

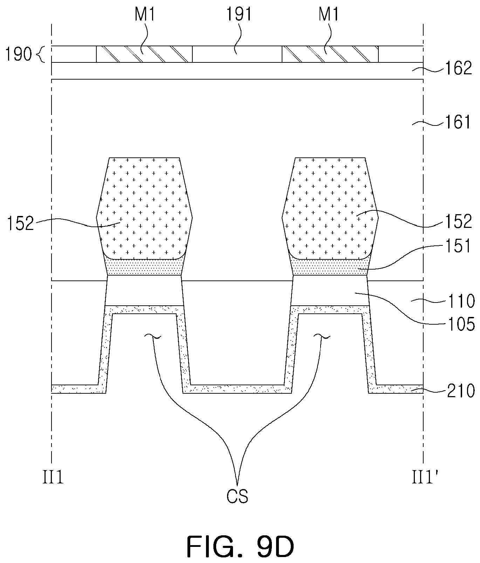

Next, referring to FIG. 8F and FIG. 9D, the dielectric base layer 220 may be removed to form second openings CS.

The second openings CS substantially correspond to the space FH from which the semiconductor pattern 105 was partially removed below each of the first and second source/drain patterns 150A and 150B. The dielectric isolation layer 210 may be formed (e.g., remain) on the internal surface of the second openings CS and the lower surface of the device isolation layer 110. In the removal process, the dielectric isolation layer 210 may be used as an etching stop layer. A width of each of the second openings CS in the first direction (e.g., the X-direction) may be defined by a plurality of dielectric isolation patterns 230, and a width of each of the second openings CS in the second direction (e.g., the Y-direction) may be defined by the space FH from which the semiconductor pattern 105 on which the dielectric isolation layer 210 is formed was partially removed (see FIG. 9B).

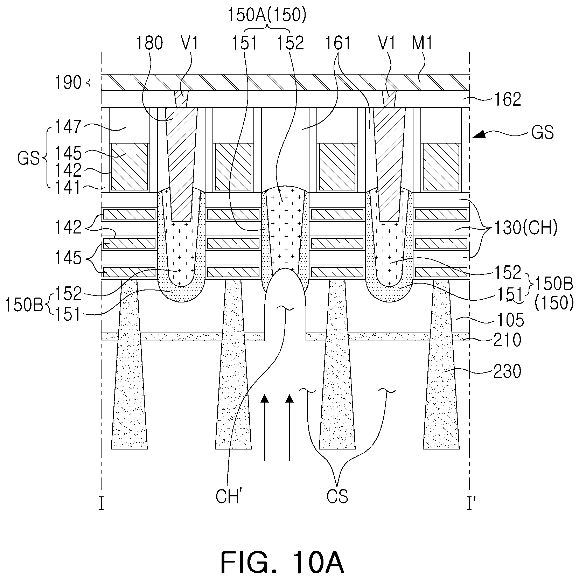

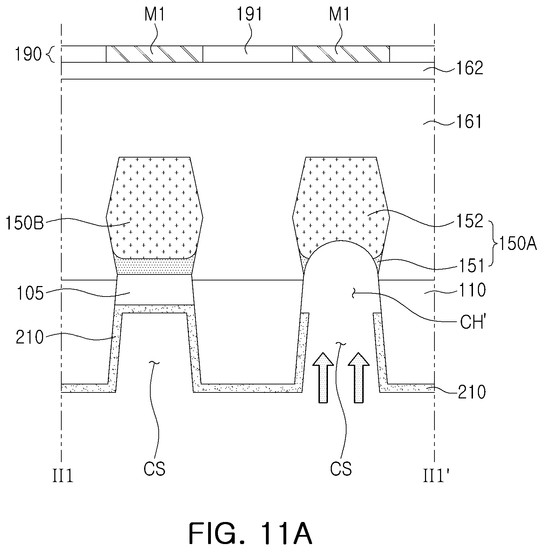

FIGS. 10A to 10D and FIGS. 11A to 11D are cross-sectional views illustrating major processes of some processes (back contact formation processes) of a method for manufacturing a semiconductor device according to an embodiment of the present disclosure. Here, FIGS. 10A to 10D are cross-sectional views corresponding to FIG. 2, respectively, and FIGS. 11A to 11D are cross-sectional views corresponding to FIG. 3A, respectively, and represent the processes of FIGS. 10A to 10D, respectively.

Referring to FIG. 10A and FIG. 11A, a third opening CH' connected to the first source/drain pattern 150A may be additionally formed in at least one of the second openings CS.

The selective removal process may be applied to the second opening CS located below the first source/drain patterns 150A. The third opening CH' connected to the first source/drain pattern 150Amay be formed by removing a portion of the dielectric isolation layer 210 exposed to the second opening CS and removing the semiconductor pattern 105 through the removed region. The second opening CS in which the third opening CH' is formed may be connected to the first source/drain pattern 150A. The dielectric isolation layer 210 may remain on sidewalls of device isolation layer 110 in the second opening CS in which the third opening CH' is formed.

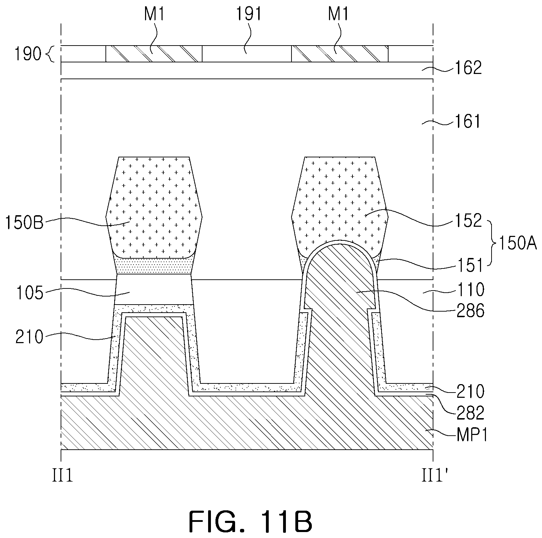

Subsequently, referring to FIGS. 10B and 11B, the second openings CS and the third opening CH' may be at least partially filled with the conductive barrier 282 and a first conductive material MP1 (or a contact plug).

Before the deposition of the first conductive material MP1, the conductive barrier 282 may be conformally formed on the surface exposed by the second openings CS and the third opening CH'. Since the conductive barrier 282 is formed at a relatively low temperature (e.g., 400°C or less) to not adversely affect the metal component of the first interconnection structure 190, it is desirable to form it with a sufficient thickness to prevent or inhibit pinhole defects. Therefore, the second openings CS and the third opening CH' may be at least partially filled to a certain level by the conductive barrier 282 having relatively high resistance.

Next, the first conductive material MP1 may be formed in the second openings CS so that the third opening CH' on the conductive barrier 282 is at least partially filled. The deposition process of the first conductive material MP1 may be performed by a non-selective deposition process, for example, CVD or PVD. Since the deposited first conductive material MP1 is grown from almost the entire surface of the conductive barrier 282, it may be a polycrystalline metal. Therefore, since the deposited first conductive material MP1 is distributed over a plurality of grain boundaries, it may have a high electrical resistance compared to a single crystal metal. The first conductive material MP1 may at least partially fill the third opening CH' to form the contact via 286 connected to the at least partially exposed region of the first source/drain pattern 150A.

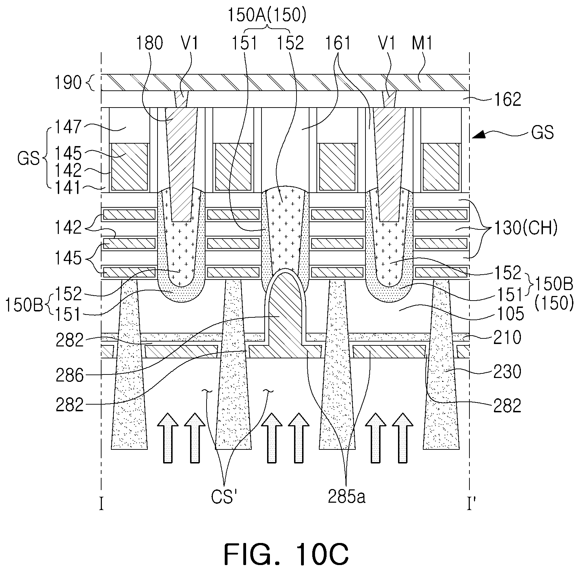

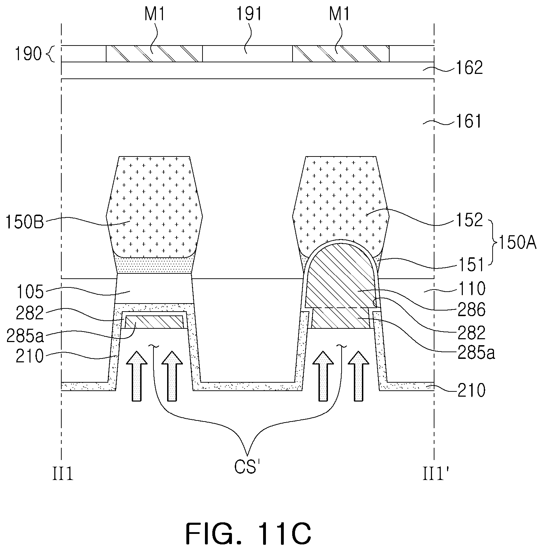

Next, referring to FIGS. 10C and 11C, an etch-back process may be performed on the deposited first conductive material MP1.

The etch-back process may be performed under a condition in which not only the first conductive material MP1 but also the conductive barrier 282 is removed. The etching process may be performed to remove the first conductive material MP1 and the conductive barrier 282 located in the second opening CS', but leave at least a portion of the first conductive material MP1 such that it has a certain thickness. The remaining first conductive material 285a may be used as a seed layer, and may be a first portion of the contact block. Here, the remaining first conductive material 285a may remain with a thickness almost free of pinholes and may have a thickness of, for example, 1 nm or more, but is not limited thereto. In the present etch-back process, the conductive barrier 282 may be removed together from most of the sidewalls of the dielectric isolation patterns 230 defining the second opening CS'. As a result, the volume of the conductive barrier 282 having relatively high resistance may be significantly reduced, thereby improving the electrical characteristics of the final lower contact structure 280.

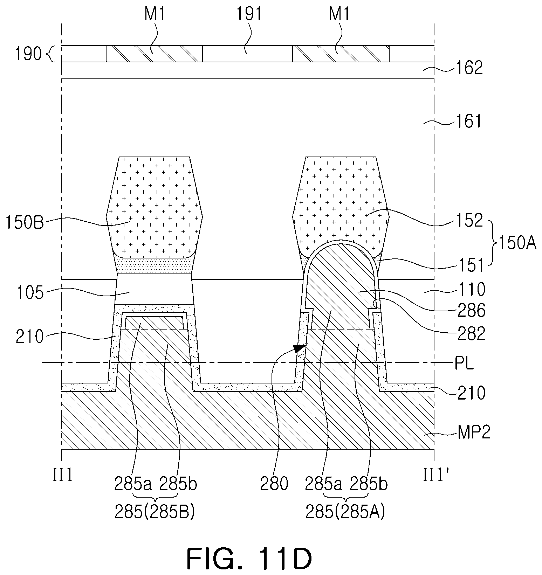

Next, referring to FIGS. 10D and 11D, the second conductive material MP2 may be deposited on the remaining first portion 285a.

In some embodiments, the second conductive material MP2 may be the same material as the first conductive material MP1. For example, the first conductive material MP1 may be molybdenum, and the second conductive material MP2 may also be the same molybdenum. However, the present disclosure is not limited thereto, and the first and second conductive materials MP1 and MP2 may be different conductive materials having substantially the same or similar crystal structures. The second conductive material MP2 may be formed by selective deposition. The second conductive material MP2 may be grown in a bottom-up manner using the remaining first portion 285a as a seed layer, and as a result, may have an almost single-crystal structure. For example, when the second conductive material MP2 is grown by an atomic layer deposition (ALD) process, MoCl₅ capable of selective deposition may be used as a precursor.

In some embodiments, both the first conductive material MP1 (see FIG. 10B) and the second conductive material MP2 (see FIG. 10D) may be deposited by an ALD process or may be deposited separately by non-selective deposition (i.e., conformal filling) and selective deposition (i.e., bottom-up growth) respectively by selecting different precursors. For example, when both the first and second conductive materials MP1 and MP2 are molybdenum (Mo), the deposition of the first conductive material MP1 may use MoO₂Cl₂ as a precursor, and the deposition of the second conductive material MP2 may use MoCl₅ as a precursor.

In this manner, by etching back the contact blocks 285 together with the conductive barrier 282 so that only a portion 285a of the first conductive material MP1 grown first remains, the volume of the conductive barrier with a high resistance in the final lower contact structure may be reduced, and the second conductive material may be re-grown using the remaining portion 285a as a seed, thereby providing a high-quality contact block 285 (of which grain boundary is minimized).

Subsequently, a polishing process may be performed so that the second conductive material MP2 is removed and the lower surfaces of the dielectric isolation patterns 230 are at least partially exposed. As a result, the contact blocks 285 may be separated from each other by the dielectric isolation patterns 230. The polishing process may be performed so that the semiconductor device 100 is reduced to a desired thickness. For example, as shown in FIGS. 10D and 11D, the polishing process may be performed until a predetermined polishing stop line PL is reached, but not limited thereto. Afterwards, referring back to FIGS. 1 to 3B, the second interconnection structure 290 may be formed on the dielectric isolation patterns 230 and the contact block 285.

According to the embodiments described above, the contact blocks are etched back together with the conductive barrier so that only a portion of the contact blocks remain, and then regrown using the remaining area as a seed, thereby minimizing the conductive barrier to improve or reduce the contact resistance and provide a high-quality contact block (of which grain boundary is minimized).

Embodiments are set out in the following Clauses:
Clause 1. A semiconductor device comprising:
   a semiconductor pattern that extends in a first direction;
   a device isolation layer that is on opposing side surfaces of the semiconductor pattern and extends in the first direction;
   a plurality of channel structures that are spaced apart from each other in the first direction and are on the semiconductor pattern;
   a plurality of gate structures that are on the plurality of channel structures and extend in a second direction that intersects the first direction;
   source/drain patterns that are respectively between the plurality of channel structures and are on the semiconductor pattern;
   a dielectric isolation layer on a lower surface of the semiconductor pattern;
   a plurality of dielectric isolation patterns that extend toward the plurality of gate structures in a third direction that is perpendicular to the first direction;
   a plurality of contact blocks that are respectively between adjacent ones of the plurality of dielectric isolation patterns and are on a lower surface of the dielectric isolation layer;
   at least one contact via that extends from at least one contact block of the plurality of contact blocks into the dielectric isolation layer to respectively contact at least one source/drain pattern among the source/drain patterns;
   a conductive barrier that is between the dielectric isolation layer and the plurality of contact blocks and contacts the at least one contact via, wherein each of the plurality of contact blocks comprises a side surface that respectively contacts sidewalls of the plurality of dielectric isolation patterns; and
   an interconnection structure that is on lower surfaces of the plurality of contact blocks, is on the plurality of dielectric isolation patterns, is on the device isolation layer, and is electrically connected to the at least one contact block.
Clause 2. The semiconductor device of Clause 1, wherein the conductive barrier has an extension portion that extends in the third direction from the sidewalls of the plurality of dielectric isolation patterns to the dielectric isolation layer.
Clause 3. The semiconductor device of Clause 2, wherein each of the plurality of contact blocks comprises a same metal material as that of the contact via, and wherein the same metal material has a single crystal structure.
Clause 4. The semiconductor device of Clause 3, wherein the same metal material comprises molybdenum (Mo) or tungsten (W).
Clause 5. The semiconductor device of any of Clauses 2-4, wherein:
   each of the plurality of contact blocks comprises a first portion that at least partially overlaps the extension portion of the conductive barrier in the first direction and a second portion that contacts the plurality of dielectric isolation patterns,
   the contact via and the first portion comprise a first metal material, and
   the second portion comprises a second metal material different from the first metal material.
Clause 6. The semiconductor device of Clause 5, wherein the first metal material comprises W, Mo, Co, or Ru.
Clause 7. A semiconductor device comprising:
   a semiconductor pattern that extends in a first direction;
   a device isolation layer that is on opposing side surfaces of the semiconductor pattern and extends in the first direction;
   a plurality of channel structures that are spaced apart from each other in the first direction and are on the semiconductor pattern;
   a plurality of gate structures that are on the plurality of channel structures and extend in a second direction that intersects the first direction;
   a first source/drain pattern and a second source/drain pattern that are on the semiconductor pattern;
   an interlayer insulating layer that is on the device isolation layer and extends around the plurality of gate structures, the first source/drain pattern, and the second source/drain pattern;
   a dielectric isolation layer on a lower surface of the semiconductor pattern;
   a plurality of dielectric isolation patterns that extend in a third direction toward the plurality of gate structures and into the dielectric isolation layer, wherein the third direction is perpendicular to the first direction;
   an upper contact that is electrically connected to the first source/drain pattern and extends into the interlayer insulating layer;
   a plurality of contact blocks that are respectively between adjacent ones of the plurality of dielectric isolation patterns and are on the lower surface of the dielectric isolation layer;
   a contact via that extends from a first contact block of the plurality of contact blocks that is adjacent to the second source/drain pattern to the second source/drain pattern and extends into the dielectric isolation layer;
   a conductive barrier that is between the dielectric isolation layer and the plurality of contact blocks and contacts the contact via, wherein each of the plurality of contact blocks comprises a side surface that respectively contacts sidewalls of the plurality of dielectric isolation patterns;
   a first interconnection structure that is on the interlayer insulating layer and is electrically connected to the upper contact; and
   a second interconnection structure that is on lower surfaces of the plurality of contact blocks, is on the plurality of dielectric isolation patterns, is on the device isolation layer, and is electrically connected to the first contact block.
Clause 8. A semiconductor device comprising:
   a semiconductor pattern extending in a first direction;
   a plurality of channel structures arranged to be spaced apart from each other on the semiconductor pattern in the first direction, wherein the plurality of channel structures include a plurality of channel patterns stacked spaced apart from each other in a vertical direction;
   a plurality of gate structures crossing the plurality of channel structures in a second direction, intersecting the first direction, and surrounding the plurality of channel patterns;
   source/drain patterns disposed between the plurality of channel structures on the semiconductor pattern and connected to side surfaces of the plurality of channel patterns;
   a dielectric isolation layer disposed on a lower surface of the semiconductor pattern;
   a plurality of dielectric isolation patterns respectively disposed in regions corresponding to the plurality of gate structures on a lower surface of the dielectric isolation layer, the a plurality of dielectric isolation patterns respectively extending toward the plurality of gate structures, and dividing the semiconductor pattern into a plurality of patterns;
   a plurality of contact blocks arranged between the plurality of dielectric isolation patterns on the lower surface of the dielectric isolation layer;
   at least one contact via extending from at least one of the plurality of contact blocks through the dielectric isolation layer to an adjacent source/drain pattern among the source/drain patterns;
   a conductive barrier disposed between the dielectric isolation layer and the plurality of contact blocks and extending to a surface of the at least one contact via, wherein each of the plurality of contact blocks has a side surface contacting sidewalls of the plurality of dielectric isolation patterns; and,
   an interconnection structure disposed on lower surfaces of the plurality of contact blocks and the plurality of dielectric isolation patterns and electrically connected to the at least one contact block.

While embodiments have been shown and described above, it will be apparent to those skilled in the art that modifications and variations could be made without departing from the scope of the present disclosure as defined by the appended claims.

## Claims

1. A semiconductor device comprising:
a semiconductor pattern (105) that extends in a first direction;
a plurality of channel structures (CH) that are spaced apart from each other in the first direction and are on the semiconductor pattern (105), wherein each of the plurality of channel structures (CH) comprises a plurality of channel patterns (130);
a plurality of gate structures (GS) that are on the plurality of channel structures (CH), extend in a second direction that intersects the first direction, and extend around the plurality of channel patterns (130);
source/drain patterns (150A, 150B) that are on the semiconductor pattern (105) and are on side surfaces of the plurality of channel patterns (130);
a dielectric isolation layer (210) on a lower surface of the semiconductor pattern (105);
a plurality of dielectric isolation patterns (230) that extend toward the plurality of gate structures (GS) in a third direction that is perpendicular to the first direction;
a plurality of contact blocks (285) that are respectively between adjacent ones of the plurality of dielectric isolation patterns (230) and are on a lower surface of the dielectric isolation layer (210);
at least one contact via (286) that extends from at least one contact block (285) of the plurality of contact blocks (285) into the dielectric isolation layer (210) to respectively contact at least one source/drain pattern (150A) among the source/drain patterns (150A, 150B);
a conductive barrier (282) that is between the dielectric isolation layer (210) and the plurality of contact blocks (285) and contacts the at least one contact via (286), wherein each of the plurality of contact blocks (285) comprises a side surface that is respectively in contact with sidewalls of the adjacent ones of the plurality of dielectric isolation patterns (230); and
an interconnection structure (290) that is on lower surfaces of the plurality of contact blocks (285), is on the plurality of dielectric isolation patterns (230), and is electrically connected to the at least one contact block (285).

2. The semiconductor device of claim 1, wherein, in a cross-sectional view, each of the plurality of dielectric isolation patterns (230) has a shape in which a width in the first direction of a first portion adjacent to the interconnection structure (290) is greater than a width in the first direction of a second portion adjacent to the plurality of gate structures (GS).

3. The semiconductor device of claim 1 or claim 2, wherein, in a cross-sectional view, each of the plurality of contact blocks (285) has a shape in which a width in the first direction of a first portion adjacent to the interconnection structure (290) is less than a width in the first direction of a second portion adjacent to the dielectric isolation layer (210).

4. The semiconductor device of any preceding claim, wherein each of the plurality of contact blocks (285) comprises a same metal material as that of the at least one contact via (286).

5. The semiconductor device of any preceding claim, wherein each of the plurality of contact blocks (285) comprises a metal having a single crystal structure.

6. The semiconductor device of any preceding claim, wherein the conductive barrier (282) has an extension portion (282E) that extends in the third direction and contacts a first dielectric isolation pattern (230) of the plurality of dielectric isolation patterns (230).

7. The semiconductor device of claim 6, wherein a length in the third direction of the extension portion (282E) of the conductive barrier (282) is in a range of 1 nm to 10 nm.

8. The semiconductor device of claim 6 or claim 7, wherein:
each of the plurality of contact blocks (285) comprises a first portion (285a) that at least partially overlaps the extension portion (282E) of the conductive barrier (282) in the first direction and a second portion (285b) that contacts the adjacent ones of the plurality of dielectric isolation patterns (230), and
the first portion (285a) and the second portion (285b) comprises different metal materials.

9. The semiconductor device of claim 8, wherein the at least one contact via (286) comprises a same metal material as that of the first portion (285a) of the plurality of contact blocks (285).

10. The semiconductor device of any preceding claim, wherein the plurality of contact blocks (285) and the at least one contact via (286) comprises tungsten or molybdenum.

11. The semiconductor device of any preceding claim, wherein the conductive barrier (282) comprises tantalum, tantalum nitride, manganese, manganese nitride, tungsten nitride, titanium, titanium nitride, or combinations thereof.

12. The semiconductor device of any preceding claim, further comprising a metal-semiconductor compound film (SC) between a first contact via of the at least one contact vias (286) and a first source/drain pattern of the at least one source/drain pattern (150A).

13. The semiconductor device of claim 12, wherein the metal-semiconductor compound film (SC) comprises at least one of titanium, cobalt, nickel, platinum, zirconium, molybdenum, and scandium.

14. The semiconductor device of any preceding claim, further comprising
a device isolation layer (110) that is on opposing side surfaces of the semiconductor pattern (105) and extends in the first direction
wherein the interconnection structure (290) is on the device isolation layer (110).

15. The semiconductor device of any preceding claim, wherein the conductive barrier (282) has an extension portion (282E) that extends in the third direction from the sidewalls of the plurality of dielectric isolation patterns (230) to the dielectric isolation layer (210), and
wherein each of the plurality of contact blocks (285) comprises a same metal material as that of the contact via (286), and wherein the metal material has a single crystal structure.
